# EUROPÄISCHE PATENTSCHRIFT

(11) **EP 0 596 266 B1**
(45) Veröffentlichungstag und Bekanntmachung des Hinweises auf die Patenterteilung: **20.09.1995**
(21) Anmeldenummer: 93116082.4
(22) Anmeldetag: 05.10.1993
(51) Int. Cl.: B23B 39/16, B23B 47/30

(54) **Adapter für Bohrmaschinen**
Adapter for drilling machines
Adaptateur pour des machines à percer

(30) Priorität: 06.11.1992 DE 4237560
(43) Veröffentlichungstag der Anmeldung: 11.05.1994
(73) Patentinhaber: Arturo Salice S.p.A., I-22060 Novedrate (Como) (IT)
(72) Erfinder:
(74) Vertreter: Gossel, Hans K., Dipl.-Ing.

(56) Entgegenhaltungen:
- AT-B- 378 714
- US-A- 1 902 179
- US-A- 3 555 963

## Beschreibung

Die Erfindung betrifft einen Adapter für Bohrmaschinen mit mindestens zwei Bohrspindeln mit Befestigungseinrichtungen für Bohrer.

Bohrmaschinen mit mehreren Bohrspindeln werden beispielsweise zum gleichzeitigen Bohren mehrerer Löcher in gleichartige Werkstücke verwendet, wie sie insbesondere bei Serienfertigungen anfallen. Eine derartige Bohrmaschine, die zum Bohren der Befestigungslöcher von Möbelscharnieren dient und gleichzeitig mit einer Montageeinrichtung zum Eindrücken der topfförmigen Scharnierteile in die gebohrten bzw. gefrästen Aufnahme- und Dübellöcher versehen ist, ist aus der DE-OS 35 08 521 bekannt.

Die üblichen Bohrmaschinen sind mit einem Bohrspindelträger für mehrere Bohrspindeln versehen, wobei zum Bohren von Löchern unterschiedlicher Muster unterschiedliche Bohrspindelträger an den Getriebeblock der Bohrmaschine anbaubar sein können. Diese austauschbaren Bohrspindelträger eignen sich aber nur zum Anbau an eine Bohrmaschine bestimmter Bauart, und sie sind selbst dann nicht für Bohrmaschinen anderer Bauart verwendbar, wenn mit diesen gleiche Muster von Bohrlöchern gebohrt werden sollen.

Aufgabe der Erfindung ist es daher, einen Universalbohrspindelträger für Bohrmaschinen zu schaffen, der sich einfach und schnell auch an Bohrmaschinen unterschiedlicher Bauarten anbauen läßt und der es somit gestattet, Bohrmaschinen unterschiedlicher Bauarten auf geänderte Muster von Bohrlöchern umzurüsten.

Erfindungsgemäß wird diese Aufgabe durch einem Adapter der eingangs angegebenen Art gelöst, der aus einem Gehäuse mit zwei zueinander parallelen Eingangswellen besteht, deren Abstand dem Abstand der beiden Bohrspindeln und deren Form den Schäften der in diesen zu befestigenden Bohrer entspricht, wobei das Gehäuse zwei auf der gegenüberliegenden Gehäuseseite angeordnete Bohrspindeln oder Gruppen von miteinander durch Getriebe verbundenen Bohrspindeln mit Befestigungseinrichtungen für Bohrer aufweist, von denen jede oder jede Gruppe mit einer der beiden Eingangswellen in Antriebsverbindung steht. Der erfindungsgemäße Adapter macht einen aufwendigen Umbau der Bohrmaschine insgesamt dadurch, daß der mit dem Getriebe in Verbindung stehende Bohrspindelträger gegen einen anderen mit anderer Anordnung der Bohr-spindeln ausgetauscht wird, entbehrlich. Der erfindungsgemäße Adapter wird wie übliche Bohrer einfach an zwei Bohrspindeln der umzurüstenden Bohrmaschine angeschlossen, ohne daß aufwendige Umrüstarbeiten der Bohrmaschine selbst notwendig wären. Da die Aufnahmen bzw. Befestigungseinrichtungen der Bohrspindeln bei allen Typen von Bohrmaschinen grundsätzlich gleich sind, paßt der erfindungsgemäße Adapter auch auf Bohrmaschinen unterschiedlicher Typen. Insbesondere in der modernen industriellen Möbelherstellung hat sich der sogenannte "Systemabstand" durchgesetzt, bei dem Befestigungsbohrungen von Möbelbeschlägen und Möbelscharnieren einen Abstand von 32 mm voneinander aufweisen. Auf diese Standardisierung sind auch die Bohrmaschinen für die Montage von Möbelbeschlägen ausgelegt, so daß die Eingangswellen des erfindungsgemäßen Adapters diesen standardisierten Bohrspindelabstand voneinander aufweisen. Natürlich kann auch ein anderer standardisierter Abstand gewählt werden. Die Eingangswellen des Adaptergehäuses werden in der üblichen Weise mit den Bohrspindeln der umzurüstenden Bohrmaschine gekuppelt. Auf der Ausgangsseite des Adaptergehäuses sind dann die Bohrspindeln in einem Muster angeordnet, das dem Muster der zu bohrenden Löcher entspricht. Dabei werden einzelne Bohrspindeln oder Gruppen von Bohrspindeln auf der Ausgangsseite des Adapters jeweils von den Bohrspindeln der Bohrmaschine angetrieben.

Der Adapter kann auch so ausgelegt sein, daß sämtliche ausgangsseitigen Bohrspindeln nur von einer Eingangswelle angetrieben werden. In diesem Falle dient die zweite mit einer Bohrspindel der Bohrmaschine gekuppelte Eingangswelle nur der Halterung und Stabilisierung des Adapters.

Zweckmäßigerweise sind vier ausgangsseitige Bohrspindeln vorgesehen, von denen zwei den Abstand der Eingangswellen aufweisen. Diese beiden Bohrspindeln gestatten es dann, Bohrungen mit dem genormten Abstand auszuführen.

Nach einer bevorzugten Ausführungsform ist vorgesehen, daß mindestens eine der beiden Eingangswellen auf der Ausgangsseite eine Kupplungseinrichtung für einen Bohrer trägt und mit einem Ritzel versehen ist, das mit zwei Zahnrädern seitlich von dieser Eingangswelle im Gehäuse gelagerter Wellen von Bohrspindeln kämmt. Mit dieser Anordnung der Bohrspindeln lassen sich geänderte Muster von Bohrlöchern bohren.

Zweckmäßigerweise liegen die seitlichen Bohrspindeln symmetrisch zu der durch die Mittellinien der Eingangswellen aufgespannten Ebene.

Bei einem möglichen Muster von Bohrlöchern ist die mit dem treibenden Ritzel versehene mittlere Bohrspindel mit einem größeren Bohrer, beispielsweise einem die Löcher für Scharniertöpfe schneidenden Fräser, versehen. Mit einem derartigen Adapter lassen sich dann in einem Arbeitsgang die Löcher zur Aufnahme des Scharniertopfes in Türen oder Klappen und gleichzeitig seitliche Dübellöcher zur Befestigung des Scharniertopfes bohren.

Zweckmäßigerweise weist das treibende Ritzel einen größeren Durchmesser auf als die Zahnräder der seitlichen Bohrspindeln.

Selbstverständlich kann die mit dem erfindungsgemäßen Adapter umgerüstete Bohrmaschine die übliche Montageeinrichtung zum Eindrücken von Möbelbeschlägen in gebohrte Löcher aufweisen, die beispielsweise aus einem schwenkbaren Bügel besteht.

Ein Ausführungsbeispiel der Erfindung wird nachstehend anhand der Zeichnung näher erläutert. In dieser zeigt:
- Fig. 1: eine übliche Bohr- und Montagemaschine zum Bohren der Befestigungslöcher für Möbelbeschläge und zum Einsetzen der Möbelbeschläge in schematischer Seitenansicht,
- Fig. 2: eine Seitenansicht des Adapters zur Umrüstung der aus Fig. 1 ersichtlichen Bohrmaschine auf eine auf geänderte Bohrlochmuster angepaßte Bohrspindelanordnung,
- Fig. 3: eine der Fig. 2 entsprechende Darstellung mit teilweise geschnittenem Adaptergehäuse, und
- Fig. 4: eine Draufsicht auf das Adaptergehäuse nach den Figuren 2 und 3 mit abgehobenem Gehäusedeckel.

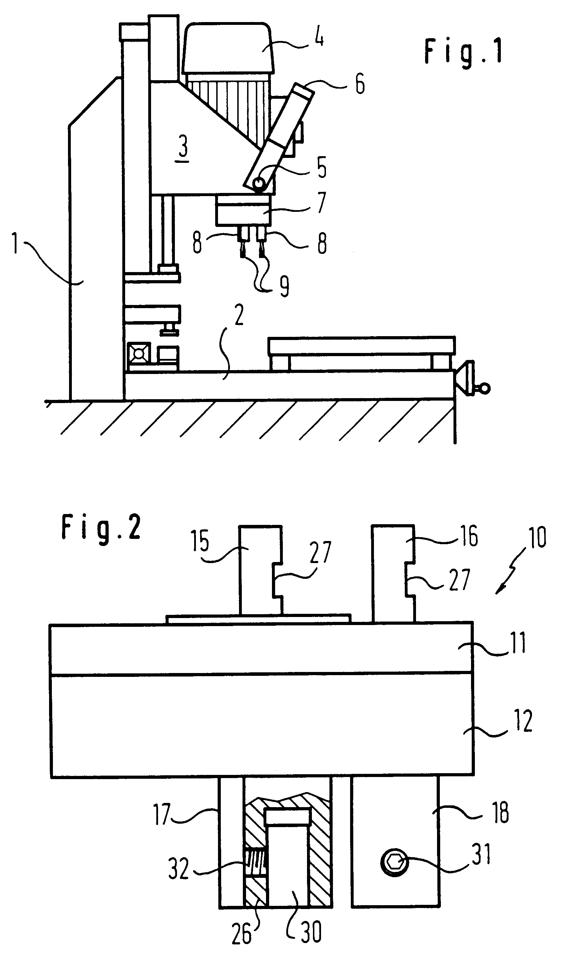

Fig. 1 zeigt schematisch eine Seitenansicht einer üblichen Bohr- und Montagemaschine für Möbelbeschläge. Im Maschinengestell 1, das mit einer Werkstückauflage 2 und nicht näher dargestellten Trag- und Führungssäulen für das Bohraggregat versehen ist, ist ein mit einem Getriebeblock 3 verbundener Support verschiebbar gelagert, der auch den Antriebsmotor 4 trägt. An seitlichen Lagerzapfen 5 des Getriebeblockes ist ein Haltebügel mit einem Einpreßstempel 6 schwenkbar gelagert, der dem Einpressen von Möbelbeschlägen in Aufnahmebohrungen dient. Der Getriebeblock 3 ist mit einem in Draufsicht kreisrunden Bohrspindelträger 7 versehen, der zwei über Ritzel angetriebene Bohrspindeln 8 aufweist, die über übliche Getriebe mit der Abtriebswelle des Antriebsmotors 4 in Antriebsverbindung stehen. Die Bohrspindeln 8 sind mit üblichen Kupplungsstücken zur Aufnahme von Bohrern 9 versehen.

Weiterhin ist die Bohrmaschine mit einer üblichen Einrichtung, beispielsweise einem Handhebel, zum Absenken des Bohrspindelträgers auf das zu bohrende oder zu bearbeitende Werkstück versehen.

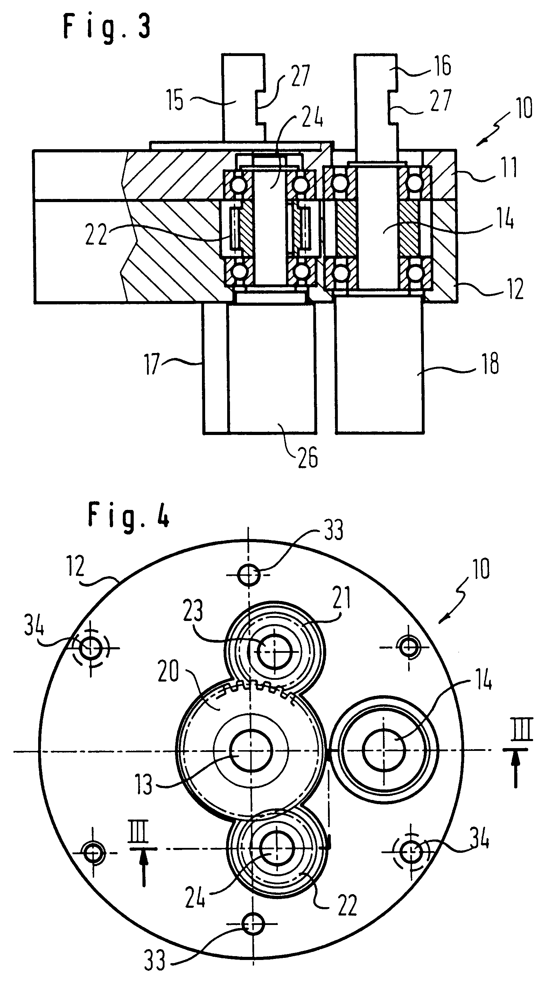

In den Figuren 2 und 3 ist der den erfindungsgemäßen Adapter bildende Bohrspindelträger 10 in seitlicher und teilweise geschnittener Ansicht dargestellt. Dabei ist der Schnitt gemäß Fig. 3 längs der Linie III-III in Fig. 4 ausgeführt.

Der Bohrspindelträger 10 besteht aus einem Adaptergehäuse mit einem unteren Gehäuseteil 12 und einem auf diesen aufgesetzten Deckel 11. In dem Gehäuse 10 sind zwei Wellen 13, 14 gelagert, die mit den Gehäusedeckel 11 überragenden Wellenzapfen 15, 16 versehen sind. Die Wellen 13, 14 weisen voneinander denselben Normabstand wie die Spindeln 8 der aus Fig. 1 ersichtlichen Bohrmaschine auf, also beispielsweise 32 mm. Auf der gegenüberliegenden Gehäuseseite sind die Wellen 13, 14 mit Kupplungsstücke aufweisenden Bohrspindeln 17, 18 zur Aufnahme von Bohrern versehen.

Die Wellen 13, 14 sind in der aus dem rechten Teil der Fig. 3 ersichtlichen Weise durch Kugellager in dem Gehäuse 10 gelagert.

Auf die Welle 13 ist in dem Gehäuse 10 ein Ritzel 20 aufgekeilt, das mit Zahnrädern 21, 22 kämmt, die auf in dem Gehäuse 10 gelagerten Spindelwellen 23, 24 befestigt sind. Die Wellen 23, 24 sind in der aus Fig. 3 ersichtlichen Weise durch Kugellager in dem Gehäuse 10 gelagert. Dabei sind die Kugellager, die zwischen sich die Zahnräder 21, 22 einfassen, über Seegerringe auf den Wellen 23, 24 befestigt. Die Spindelwellen tragen auf der Gehäuseunterseite Spindeln 26 mit Kupplungsstücken zum Aufnehmen und Befestigen von Bohrern.

Die den Gehäusedeckel 11 überragenden Wellenzapfen 15, 16 sind mit Abflachungen 27 versehen, die den üblichen Abflachungen der Bohrer entsprechen, die in die Kupplungsstücke der Spindeln 8 der Bohrmaschine einsetzbar sind, so daß die Wellenzapfen 15, 16 anstelle der Bohrer 9 mit den Spindeln der Bohrmaschine gekuppelt werden können.

Wie aus den Figuren 3 und 4 ersichtlich ist, ist der Wellenzapfen 16 der Spindelwelle 14 unmittelbar mit dem Kupplungsstück der Spindel 18 verbunden, ohne mit dem Wellenzapfen 15 in getriebemäßiger Antriebsverbindung zu stehen.

Die Kupplungsstücke der Bohrspindeln 17, 18 und 26 sind in der aus Fig. 2 ersichtlichen Weise mit Sacklöchern 30 versehen, in die die Bohrer einsetzbar und durch Schrauben 31 festlegbar sind, die in radiale Gewindebohrungen 32 eingeschraubt sind.

Das Gehäuse 12 weist eine kreisrunde Form auf und ist mit Zentrierbohrungen 33 und Bohrungen 34 zum Einschrauben der nicht dargestellten Deckelschrauben versehen.

Wird der aus den Figuren 2 bis 4 ersichtliche Adapter mit den Kupplungen der Spindeln 8 der Bohrmaschine 1 gekuppelt, lassen sich der Spindelanordnung des Adapters entsprechende Bohrungen ausführen. Der Adapter wird von der Bohrmaschine direkt mitbewegt, so daß er sofort nach dem Einsetzen in die Kupplungsstücke der Bohrspindeln 8 funktionsfähig ist. Es ist lediglich noch erforderlich, die Anschläge der Vorschubeinrichtung der Bohrmaschine auf den durch den Adapter geänderten Abstand einzustellen.

Bei dem dargestellten Ausführungsbeispiel des den Adapter bildenden Bohrspindelträgers 10 können beispielsweise zwei Bohrer von 10 mm Durchmesser in die Bohrspindeln 26 und ein Bohrer oder Fräser mit einem Durchmesser von 35 mm in die zentrale Bohrspindel 17 eingesetzt werden, so daß sich in einem Arbeitsgang in eine Tür Ausnehmungen für einen Scharniertopf und seitliche Bohrungen für der Befestigung des Scharniertopfes dienende Dübel anbringen lassen.

Weiterhin besteht die Möglichkeit, nur zwei Bohrer mit einem Durchmesser von 10 mm in die Bohrspindeln 17 und 18 einzusetzen, so daß dann in eine Möbelwand Bohrungen für die Dübel einer Grundplatte mit einem Abstand von 32 mm gebohrt werden können.

Bei der Bohrung der Löcher für den Scharniertopf bleibt die Bohrspindel 18 unbenutzt. Der obere Wellenzapfen 16 der Bohrspindel 14 dient aber der Befestigung, Ausrichtung und Stabilisierung des Bohrspindelträgers 10.

In entsprechender Weise können die Adapter auf abweichende Muster von Bohrlochanordnungen ausgelegt werden.

## Patentansprüche

1. Adapter für Bohrmaschinen mit mindestens zwei Bohrspindeln (8) mit Kupplungsstücken für Bohrer,
**gekennzeichnet durch**
ein Gehäuse (10) mit zwei zueinander parallelen Eingangswellen (15, 16), deren Abstand dem Abstand der beiden Bohrspindeln (8) und deren Form den Schäften der in diesen zu befestigenden Bohrer entspricht,
und mit zwei auf der gegenüberliegenden Gehäuseseite angeordneten Bohrspindeln (17, 18) oder Gruppen von miteinander durch Getriebe verbundene Bohrspindeln (17, 26) mit Kupplungsstücken für Bohrer, von denen jede oder jede Gruppe mit einer der beiden Eingangswellen (15, 16) in Antriebsverbindung steht.

2. Adapter nach Anspruch 1, dadurch gekennzeichnet, daß sämtliche ausgangsseitigen Bohrspindeln nur von einer Eingangswelle angetrieben werden.

3. Adapter nach Anspruch 1, dadurch gekennzeichnet, daß vier ausgangsseitige Bohrspindeln (17, 18, 26) vorgesehen sind, von denen zwei (17, 18) den Abstand der Eingangswellen (15, 16) aufweisen.

4. Adapter nach einem der Ansprüche 1 bis 3, dadurch gekennzeichnet, daß mindestens eine der beiden Eingangswellen (15) auf der Ausgangsseite des Gehäuses (10) eine Kupplungseinrichtung (17) für einen Bohrer trägt und mit einem Ritzel (20) versehen ist, das mit zwei Zahnrädern (21, 22) seitlich zu dieser Eingangswelle (15) im Gehäuse gelagerter Wellen (23, 24) von Bohrspindeln (26) kämmt.

5. Adapter nach Anspruch 4, dadurch gekennzeichnet, daß die seitlichen Bohrspindeln (26) symmetrisch zu der durch Mittellinien der Eingangswellen (15, 16) aufgespannten Ebene liegen.

6. Adapter nach Anspruch 4 oder 5, dadurch gekennzeichnet, daß das treibende Ritzel (20) einen größeren Durchmesser aufweist als die Zahnräder (21, 22) der seitlichen Bohrspindeln (26).

## Claims

1. Adapter for drilling machines with at least two drilling spindles (8) having coupling pieces for drills,
**characterised by**
a housing (10) with two input shafts (15, 16) parallel to each other, the centre distance of which corresponds to the centre distance of the two drilling spindles (8), and the shape of which corresponds to the shanks of the drills secured in said drilling spindles (8),
with, arranged on the opposite side of the housing, drilling spindles (17, 18) or groups of drilling spindles (17, 26) interconnected by gears, and with coupling pieces for drills, of which each drilling spindle or each group is connected to one of the two input shafts (15, 16) by a drive arrangement.

2. Adapter according to Claim 1, characterised in that all the output-end drilling spindles are driven by just one input shaft.

3. Adapter according to Claim 1, characterised in that four output-end drilling spindles (17, 18, 26) are provided, of which two (17, 18) exhibit the centre distance of the input shafts (15, 16).

4. Adapter according to one of Claims 1 to 3, characterised in that at least one of the two input shafts (15) carries at the output end of the housing (10) a coupling device (17) for a drill, and is provided with a pinion (20) which meshes with two gears (21, 22) located on shafts (23, 24) of drilling spindles (26) mounted laterally in the housing relative to said input shaft (15).

5. Adapter according to Claim 4, characterised in that the lateral drilling spindles (26) lie symmetrical to the plane passing through the centrelines of the input shafts (15, 16).

6. Adapter according to Claim 4 or 5, characterised in that the drive pinion (20) has a greater diameter than the gears (21, 22) of the lateral drilling spindles (26).

## Revendications

1. Adaptateur pour machines à percer comportant au moins deux broches de perçage (8) avec des pièces de raccordement pour la perceuse
caractérisé par
un boîtier (10) comportant deux arbres d'entrée réciproquement parallèles (15, 16) dont la distance correspond à la distance des deux broches de perçage (8) et dont la forme correspond aux tiges des perceuses à fixer dans ceux-ci,
et deux broches de perçage (17, 18) ou des groupes de broches de perçage (17, 26) disposés sur le côté opposé du boîtier et raccordés entre eux par des engrenages avec des pièces de raccordement pour perceuses, dont chacune ou chaque groupe est en raccordement d'entraînement avec l'un des deux arbres d'entrée (15, 16).

2. Adaptateur selon la revendication 1, caractérisé en ce que toutes les broches de perçage côté sortie ne sont entraînées que par un seul des arbres d'entrée.

3. Adaptateur selon la revendication 1, caractérisé en ce que quatre broches de perçage (17, 18, 26) sont prévues du côté de la sortie, dont deux (17, 18) présentent la distance des arbres d'entrée (15, 16).

4. Adaptateur selon l'une quelconque des revendications 1 à 3, caractérisé en ce qu'au moins un des deux arbres d'entrée (15) porte un dispositif de raccordement (17) du côté de la sortie du boîtier (10) pour une perceuse et est pourvu d'un pignon qui est en prise avec deux roues dentées (21, 22) d'arbres (23, 24) de broches de perçage (26) logées latéralement dans le boîtier par rapport à l'arbre d'entrée (15).

5. Adaptateur selon la revendication 4, caractérisé en ce que les broches de perçage (26) latérales sont placées symétriquement par rapport au plan décrit par les lignes médianes des arbres d'entrée (15, 16).

6. Adaptateur selon la revendication 4 ou 5, caracérisé en ce que le pignon moteur (20) présente un diamètre supérieur au roues dentées (21, 22) des broches de perçage (26) latérales.
